(19) Europäisches Patentamt
European Patent Office
Office européen des brevets

(11) **EP 1 597 535 B1**

(12) **EUROPÄISCHE PATENTSCHRIFT**

(45) Veröffentlichungstag und Bekanntmachung des Hinweises auf die Patenterteilung:
**01.07.2009 Patentblatt 2009/27**

(21) Anmeldenummer: **04713855.7**

(22) Anmeldetag: **24.02.2004**

(51) Int Cl.:
*G01B 7/30* (2006.01)    *G01R 33/09* (2006.01)

(86) Internationale Anmeldenummer:
**PCT/EP2004/001791**

(87) Internationale Veröffentlichungsnummer:
**WO 2004/074764 (02.09.2004 Gazette 2004/36)**

(54) **MAGNETORESISTIVER SENSOR ZUR BESTIMMUNG EINES WINKELS ODER EINER POSITION**

MAGNETORESISTIVE SENSOR FOR DETERMINING AN ANGLE OR A POSITION

CAPTEUR MAGNETORESISTIF SERVANT A DETERMINER UN ANGLE OU UNE POSITION

(84) Benannte Vertragsstaaten:
**AT FR GB HU NL**

(30) Priorität: **24.02.2003 DE 10308030**

(43) Veröffentlichungstag der Anmeldung:
**23.11.2005 Patentblatt 2005/47**

(73) Patentinhaber: **HL-Planar Technik Gmbh**
**44227 Dortmund (DE)**

(72) Erfinder:
• **BARTOS, Axel**
**45731 Waltrop (DE)**
• **MEISENBERG, Armin**
**44227 Dortmund (DE)**
• **DETTMANN, Fritz**
**35619 Braunfels-Philippstein (DE)**

(74) Vertreter: **Tilmann, Max Wilhelm et al**
**König Szynka Tilmann von Renesse**
**Patentanwälte Partnerschaft**
**Postfach 11 09 46**
**40509 Düsseldorf (DE)**

(56) Entgegenhaltungen:
EP-A- 0 730 162          EP-A- 0 863 406
DE-A- 3 514 457          DE-A- 10 113 131
DE-A- 10 127 754         DE-A- 10 130 620
DE-A- 19 649 265         DE-A- 19 839 450
DE-A- 19 949 714         DE-C- 19 743 335
US-A- 5 686 837          US-A- 5 945 825
US-A- 6 020 738          US-A- 6 104 187
US-A1- 2002 006 017

**Beschreibung**

Die Erfindung betrifft magnetoresistive Sensoren zur Bestimmung von Winkeln, die ein drehbarer Magnet gegenüber dem Sensor einnimmt, oder von Positionen, wobei der Sensor einem magnetischen Maßstab gegenübersteht und ein periodisches magnetisches Muster trägt. Solche Winkel- und Positionsmessanordnungen werden in großer Zahl beispielsweise im Maschinenbau, in der Automobiltechnik oder in der Feinmechanik angewendet.

Es sind unterschiedlich aufgebaute Magnetfeldsensoren auf der Basis des Riesigen (giant) magnetoresistiven (GMR) Effektes sowie des anisotropen magnetoresistiven (AMR) Effektes bekannt.

In der Schrift EP 0 730 162 wird eine Sensorbrücke beschrieben, deren Widerstände aus Streifen von GMR-Schichtsystemen bestehen, die alle dieselbe Richtung der fest eingeprägten Magnetisierung aufweisen. Das Sensorsignal kommt dadurch zustande, das wegen der ungleichen Breiten der Streifen der unterschiedlichen Widerstände die Verdrehung der freien Magnetisierung im angelegten Magnetfeld differiert und damit auch deren Widerstandsänderung. Innerhalb des jeweiligen Widerstandsstreifens ändert sich die Richtung des Stroms entlang der Längsausdehnung des Streifens jedoch nicht.

Der in der Patentschrift US 5,686,837 vorgeschlagene Magnetfeldsensor auf der Basis von GMR-Schichtsystemen erreicht eine höhere Empfindlichkeit und Signalamplitude dadurch, dass die feste Magnetisierung der Schichten der diagonalen Widerstände der Brücke gleiche Richtung hat, dass aber die feste Magnetisierung der Schichten der Widerstände jedes Brückenzweiges entgegen gesetzt ist. Außerdem ist die Drehbarkeit der Magnetisierung der freien Schicht im äußeren Feld durch die Kreisförmigkeit der Schichtbereiche erhöht.

Eine Anordnung, mit der die entsprechenden Richtungen der festen Magnetisierung, die in jedem gesamten Brückenwiderstand jeweils übereinstimmt, wird in der Schrift DE 101 30 620 angegeben.

Die Patentschrift 197 43 335 zeigt, wie mit einer einzigen Brücke des beschriebenen Aufbaus die Richtung eines Magnetfeldes in der Sensorebene im Bereich von 360° bestimmt werden kann. Ein Leiter, der unmittelbar über der Sensorebene angebracht ist, kreuzt alle Widerstandsstreifen der Brückenwiderstände unter bestimmten Winkeln und kann wahlweise vom Brückenstrom durchflossen sein. Das dadurch entstehende Magnetfeld wird dem äußeren Feld überlagert. Aus den Messwerten mit und ohne dieses entstehende Feld ist die Zuordnung der Richtung im 360°-Bereich möglich. Das Zusatzfeld hat auf die Richtung der festen Magnetisierung keinen Einfluss. Diese ist auch hier im Bereich jedes Widerstandes immer dieselbe.

In der Patentschrift DE 35 14 457 wird eine AMR-Sensorbrücke vorgeschlagen. Alle vier Brückenwiderstände bestehen aus zueinander parallelen Streifen. Die Gegenläufigkeit der Widerstandsänderungen der Brückenwiderstände wird durch Barberpole-Strukturen erreicht: Auf den AMR-Streifen befindet sich unter einem Neigungswinkel von $\pm 45°$ eine Vielzahl hochleitfähiger Streifen in konstantem Abstand aus nichtmagnetischem Material. Dadurch wird der Winkel der Stromrichtung senkrecht zur Längsrichtung der hochleitfähigen Streifen eingestellt. Die Streifen der Widerstände desselben Brückenzweiges tragen entgegengesetzt geneigte Leitstreifen und ändern so ihren Widerstand gegenläufig. Die Stromrichtung in jedem Widerstand ist jedoch einheitlich und konstant.

Magnetoresistive Sensoren zur Bestimmung von Winkeln oder Positionen sind bekannt. Eine Zusammenfassung des Standes der Technik zur analogen Bestimmung von Winkeln mittels magnetoresistiver Sensoren auf der Basis des anisotropen magnetoresistiven (AMR) Effektes, des gigantischen magnetoresistiven (GMR) Effektes und des Tunneleffektes zwischen magnetoresistiven Schichten (TMR) wird in der Schrift WO 02/06845 A1 gegeben. Beim AMR-Effekt wird der Widerstand eines Schichtstreifens durch den Winkel $\alpha$ zwischen der Stromrichtung und der Richtung der Magnetisierung bestimmt. Er lässt sich durch die Beziehung $R(\alpha) = R_0 + (\Delta R/2)(1-\cos(2\alpha))$ bestimmen. Daraus ist ersichtlich, dass die Widerstandsänderung bereits nach der Änderung des Winkels $\alpha$ um 180° eine volle Periode durchlaufen hat. Passt sich die Richtung der Magnetisierung der Richtung des auf den Schichtstreifen wirkenden Feldes eines in der Nähe drehbar gelagerten Dauermagneten an, so erreicht man bei einer vollen Drehung des Dauermagneten zwei volle Periodendurchläufe der Widerstandsänderung. Diese kann bei Stromfluss durch den Schichtstreifen als Spannungsänderung gemessen werden.

Beim GMR- und beim TMR-Effekt ist der Widerstand eines Schichtstreifens bzw. eines Tunnelüberganges vom Winkel $\beta$ zwischen den Richtungen der Magnetisierung von zwei Schichten oder Schichtkomponenten magnetoresistiven Materials abhängig. Wird in der einen Schichtkornponente die Magnetisierungsrichtung durch einen im direkten Kontakt vorhandenen natürlichen oder künstlichen Antiferromagneten festgehalten und nur die Magnetisierungsrichtung der zweiten Komponente folgt dem angelegten Feld des drehbaren Dauermagneten, so gilt für die Widerstandsänderung die Beziehung $R(\beta) = R_0 + (\Delta R/2) \cdot (1-\cos(\beta))$. Für eine Umdrehung des Dauermagneten ergibt sich hier nur eine volle Periode der Widerstandsänderung oder der als Signal nutzbaren Spannung am Schichtstreifen oder Tunnelübergang.

Entsprechend den angegebenen Formeln ergibt sich eine ideale Umformung eines Winkels in eine Kosinusfunktion. In der Praxis erweist es sich jedoch, das diese Umwandlung nur fehlerbehaftet durchführbar ist. In den Signalen treten Oberwellen der jeweiligen Grundwelle auf, deren Periodenlängen einen ganzzahligen Bruchteil der oben angegebenen 180° bzw. 360° betragen. Der Grund für die Fehler liegt darin, dass die angenommene Übereinstimmung der Richtung der Magnetisierung der Schichten mit der Richtung des angelegten magnetischen Feldes nicht in ausreichendem Maße vorhanden ist. Im Falle der AMR-Winkelsensoren kann die Übereinstimmung der genannten Richtungen durch hohe magnetische Feldstärken des Dauermagneten verbessert werden. Das gelingt jedoch nur bei Einsatz teurer hochkoerzitiver Dauermagnetwerkstoffe oder mechanisch aufwendiger Anbringung des Dauermagneten in unmittelbarster Nähe des Sensors. Bei GMR- oder TMR-Sensoren führt die Verwendung immer höherer Magnetfeldstärken nicht zur Verbesserung der Sinusförmigkeit des Signals, da diese Feldstärke eine Verdrehung der Magnetisierung der an den Antiferromagneten gekoppelten magnetoresistiven Schicht bewirken.

Für die Abweichung der Richtung der Magnetisierung der freien und AMR-Schichtstreifen von der Richtung des angelegten Magnetfeldes kommen zwei Ursachen in Frage. Die erste ist grundsätzlich physikalischer Art und wurde bereits in der Offenlegungsschrift DE 198 39 450 A1 mit der Gleichung genannt, die der Winkel $\phi$ der Richtung der Magnetisierung mit der Streifenlängsrichtung erfüllen muss und die gegeben ist durch

$$H_x/H_0 \cdot \tan(\phi) + \sin(\phi) - H_y/H_0 = 0.$$

$H_x$ ist dabei die Magnetfeldkomponente in Streifenlängsrichtung und $H_y$ die Komponente quer dazu. Die Übereinstimmung des Winkels $\phi$ mit dem oben angegebenen Winkel $\alpha$, für den die Gleichung

$$\tan(\alpha) = H_y/H_x$$

gilt, ist nur für den Fall gegeben, dass $H_x/H_0$ und $H_y/H_0$ sehr große Werte annehmen, was mit der genannten Bedingung des notwendigen Einsatzes hoher Feldstärken übereinstimmt. Der zweite Grund liegt darin, dass in begrenzten Winkelbereichen bei schwächeren Feldern des Dauermagneten eine Aufspaltung der Magnetisierungsrichtung in Domänen, besonders an Streifenenden und -rändern auftritt, die zu vom idealen Verhalten abweichenden Widerstandswerten und zu Hysterese in den Winkelbereichen führt.

In den beiden genannten Schriften WO 02/06445 A1 und DE 198 39 450 A1 wurden zur Verbesserung der mit magnetoresistiven Winkelsensoren erreichbaren Messgenauigkeit Anordnungen der Schichtstreifen, die jeweils magnetoresistive Widerstände bilden, angegeben, die zur Herausfilterung der Oberwellen aus den Ausgangssignalen der Sensoren geeignet sind. Diese Filterung ist auch bei geringeren Magnetfeldstärken wirksam. Sie wird dadurch erreicht, dass im Falle der AMR-Sensoren anstelle von langen geraden magnetoresistiven Streifen einander paralleler Längsrichtung in Sensoren ohne Oberwellenfilterung zwei oder mehr Gruppen von parallelen geraden Streifen mit genau festgelegten Winkeln zwischen den Längsrichtungen der Streifen benutzt werden. Je mehr Gruppen von Streifen eingesetzt werden um so höher ist die Ordnung der Oberwellen, bis zu der sie aus dem Signal herausgefiltert werden. Nachteiligerweise ergeben sich jedoch mit jeder neuen Gruppe von Streifen mit neuem festen Neigungswinkel gegen die schon vorhandenen auch neue Winkelbereiche des angelegten Magnetfeldes, dessen Winkel gemessen werden muss, in denen eine Aufspaltung in Domänen und damit Hysterese auftritt. Das gilt insbesondere für Feldstärken, die nicht sehr hoch über der Anisotropiefeldstärke der Streifen liegen.

Im Falle von GMR- und TMR-Sensoren können zwar durchweg parallele lange magnetoresistive Streifen eingesetzt werden. In den unterschiedlichen Gruppen von Streifen müssen jedoch die Richtungen der Magnetisierung der an den jeweiligen Antiferromagneten gekoppelten Schichten genau festgelegte Winkel miteinander bilden. So lassen sich Magnetisierungskomponenten, die senkrecht zur Streifenlängsrichtung gerichtet sind, grundsätzlich nicht vermeiden und es kommt auch hier zur Ausbildung einer mit der Zahl der Gruppen von Streifen anwachsenden Zahl von Winkelbereichen, in denen Hysterese, besonders bei den wirtschaftlich erzeugbaren geringeren Feldstärken, auftritt.

Magnetoresistive Sensoren zur Bestimmung von Positionen, die nahe der Oberfläche von magnetischen Maßstäben in Messrichtung beweglich angeordnet sind, bestimmen den jeweiligen Positionswert aus dem Winkel, den das Magnetfeld am Ort des Sensors mit einer Streifenrichtung bildet. Besteht der magnetische Maßstab aus periodisch in abwechselnder Richtung magnetisiertem dauermagnetischem Material, so ändert sich dieser Winkel mit Fortschreiten in Messrichtung näherungsweise linear. Die Probleme, die zum Erreichen hoher Messgenauigkeiten gelöst werden müssen, entsprechen im wesentlichen denen bei Winkelsensoren. Das trifft vor allem auf die Anwendung der Filterung von Oberwellen zu.

Die Aufgabe der Erfindung besteht deshalb darin, den Aufbau von Positions- und Winkelsensoren auf der Basis der magnetoresistiven Effekte anzugeben, deren Messgenauigkeit durch Herausfiltern von Oberwellenanteilen aus den Signalen erhöht ist, ohne dass Bereiche mit messwertverfälschender Hysterese in geringeren Magnetfeldstärken auftreten.

Diese Aufgabe wird durch die Schaffung von Sensorelementen gelöst, die den Merkmalen des Anspruchs 1 entsprechen. Wesentlich ist hier vor allem, dass es entsprechend der Erfindung keine sprunghafte Änderung des widerstandsbestimmenden Winkels in den magnetoresistiven Streifen, aus denen die Sensorwiderstände aufgebaut sind, vorkommen. Im Falle der Nutzung des AMR-Effektes ist der Winkel zwischen der Stromrichtung und der Richtung der Magnetisierung der widerstandsbestimmende Winkel. Um eine Oberwellenfilterung in den magnetoresistiven Widerständen zu bewerkstelligen, sind in den Streifen unterschiedliche widerstandsbestimmende Winkel nötigt Diese können ohne sprunghafte Änderung des widerstandsbestimmenden Winkels durch die Form der Ränder der Streifen realisiert werden. Sind beispielsweise beide Streifenränder als parallel verlaufende Sinuskurven darstellbar, so wird die Stromrichtung in den Streifen sich dieser Form anpassen und der Winkel der Stromrichtung gegen die Längsrichtung des Streifens, die durch die gerade Verbindung seiner Endpunkte gegeben ist, verläuft ebenfalls in Form einer Sinusfunktion. Die Richtung der Magnetisierung des magnetoresistiven Materials der Streifen wird bei geringeren Magnetfeldstärken durch die Feldstärke des an den Streifen anliegenden Magnetfeldes, durch die Kristallanisotropiefeldstärke des Materials und durch die Formanisotropiefeldstärke bestimmt. Die Kristallanisotropie des Materials hat im Bereich des Sensorchips überall gleiche Stärke und Richtung. Die Formanisotropie verläuft im angegebenen Beispiel ebenfalls parallel zum Rand. So ändert sich auch die Richtung der Magnetisierung entlang des Streifens nur stetig. Somit sind sprunghafte Änderungen der Richtung der Magnetisierung nicht vorhanden und eine Ursache für die Aufspaltung in Domänen ist hier nicht gegeben.

Für die Änderung der Richtung der Stromes in Streifen aus AMR-Material gibt es neben der Gestaltung des Streifenrandes eine zweite Möglichkeit. Diese besteht in der Anwendung der Barberpol-Struktur, die bereits in der Offenlegungsschrift DE 35 14 457 dargestellt wird, allerdings ohne jeden Bezug auf Oberwellenfilterung in der Winkel- und Längenmessung. Bei der Barberpol-Struktur befindet sich auf den Streifen magnetoresistiven Materials eine Vielzahl von Leitschichtstreifen in einem Abstand, der von der gleichen Größenordnung ist, wie die Breite der magnetoresistiven Streifen, wobei die Längsrichtungen der Leitschichtstreifen mit der der magnetoresistiven Streifen Zwischenwinkel bilden. Wegen der vergleichsweise hohen Leitfähigkeit der Leitschichtstreifen steht die Stromrichtung etwa senkrecht zu deren Längsrichtung. Durch unterschiedlich gewählte Zwischenwinkel sind so unterschiedliche Stromrichtungen in magnetoresistiven Streifen mit geraden und parallelen Kanten einstellbar, so dass bei gleicher Magnetisierungsrichtung die benötigten unterschiedlichen widerstandsbestimmenden Winkel realisierbar sind. Eine größere Zahl mit unterschiedlichen Winkeln gegeneinander geneigter magnetoresistiver Streifen ist so nicht erforderlich, und ein vermehrtes Auftreten hysteretischer Bereiche bei der Winkelmessung ist ausgeschlossen.

Im Falle des GMR-Effektes sind zur Winkelmessung besonders solche Schichtsysteme geeignet, deren erste Komponente eine Magnetisierung aufweist, deren Richtung im wesentlichen dem Magnetfeld eines gegenüber dem Sensor drehbaren Magneten folgen kann und bei denen die Magnetisierung der zweiten Komponente durch Kopplung an eine weitere magnetische Komponente im wesentlichen unabhängig von der Richtung des einwirkenden Magnetfeldes bleibt. Der widerstandsbestimmende Winkel ist der zwischen den Richtungen der Magnetisierungen der ersten und der zweiten Komponente. Zur Oberwellenfilterung sind unterschiedliche widerstandsbestimmende Winkel erforderlich. Erfindungsgemäß wird das dadurch erreicht, dass die Richtung der Magnetisierung der zweiten Komponente entlang der Längsrichtung der magnetoresistiven Streifen stetig verändert ist. Eine solche stetige Veränderung wird beispielsweise so eingestellt, dass die gegenüberliegenden Streifenränder durch gleiche stetig variierende Funktionen darstellbar sind, dass die weitere Komponente ein Antiferromagnet ist, an dessen Achsenrichtung die Magnetisierung der zweiten Komponente gekoppelt ist, und dass die Einstellung der Achsenrichtung durch das Magnetfeld eines Stromes durch die magnetoresistiven Streifen erfolgt ist. Damit steht die Richtung der Magnetisierung der zweiten Komponente immer senkrecht auf dem Rand und ändert sich stetig in Längsrichtung der Streifen. Die stetige Änderung der Richtung der Magnetisierung der zweiten Komponente vermeidet sowohl in der zweiten als auch wegen einer nicht vermeidbaren schwächeren Kopplung zwischen erster und zweiter Komponente in der ersten Komponente die Ausbildung von Domänen und damit ein vermehrtes Auftreten von Hystereseberichen. Die Einstellung der Magnetisierungsrichtung der zweiten Komponente kann vorteilhaft durch Anwendung eines konstanten Magnetfeldes in Kombination mit dem Feld eines Stromes durch die Streifen erfolgen. So sind unterschiedliche stetige Funktionen für den Verlauf des widerstandsbestimmenden Winkels entlang der Längsrichtung realisierbar.

Sowohl für den Fall des Einsatzes von AMR- als auch von GMR-Sensoren werden in den Unteransprüchen konkrete Funktionen für den Verlauf der Ränder der magnetoresistiven Streifen angegeben. Die Wahl des optimalen Verhältnisses zwischen Periodenlänge und Amplitude der periodischen Randfunktionen erfolgt vorteilhafterweise als Ergebnis einer Berechnung, die Oberwellenanteile und Amplitude der Signale bewertet.

Weitere Erläuterungen der Erfindung werden anhand von Ausführungsbeispielen gegeben. Folgende Zeichnungen sind beigefügt:

Fig. 1:     Widerstandsbestimmender Winkel beim AMR-Effekt,

Fig. 2:     Widerstandsbestimmender Winkel beim GMR-Effekt,

Fig. 3:     Durch die Streifenränder eingestellte Stromrichtung für AMR-Sensoren,

Fig. 4:     AMR-Längensensorbrücke entsprechend der Erfindung,

Fig. 5:     Erfindungsgemäße AMR-Winkelsensorbrücke,

Fig. 6:     Durch Barberpol-Struktur eingestellte Stromrichtung für AMR-Sensoren,

Fig. 7:     Erfindungsgemäßer AMR-Längensensor mit Barberpol-Struktur,

Fig. 8:     Stetig geänderter Verlauf der feldunabhängigen Magnetisierungs richtung bei GMR-Sensoren,

Fig. 9     Erfindungsgemäße GMR-Winkelsensorbrücke.

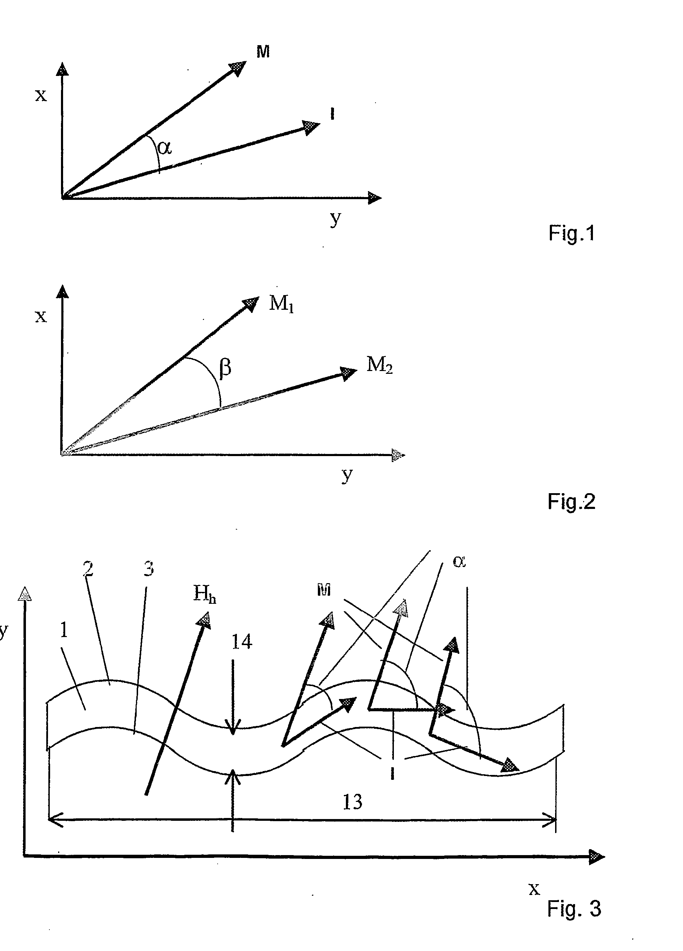

In Fig. 1 ist die x-y-Schichtebene eines AMR-Streifens dargestellt. Die Streifenlängsrichtung soll hier mit der x-Achse zusammenfallen. Für einem Punkt des Streifens ist die Richtung des Stromes I eingezeichnet. Im allgemeinen stimmt diese Richtung nicht mit der Streifenlängsrichtung X überein. Unter Einwirkung eines äußeren Magnetfeldes stellt sich die Magnetisierung M im betrachteten Punkt in die eingezeichnete Richtung ein. Zwischen der Richtung des Stromes I und der Richtung der Magnetisierung M liegt der Winkel $\alpha$. Der spezifische Widerstand $\rho_a$ der magnetoresistiven Schicht ist durch diesen Winkel bestimmt zu

$$\rho_a\,(\alpha) = \rho_{a0} + (\Delta\rho_a\,/2)\cdot(1-\cos(2\cdot\alpha))$$

mit $\rho_{a0}$ als nicht feldabhängigem Anteil und $\Delta\rho_a$ als der Amplitude der feldabhängigen Änderung des spezifischen Widerstandes. $\alpha$ ist der widerstandsbestimmende Winkel in jedem Punkt des Streifens. Der spezifische Widerstand ist bei in Streifenlängsrichtung x variierender Richtung des Stromes I und der Magnetisierung M ebenfalls eine Funktion von x.

Fig. 2 zeigt in einem Punkt in der x-y-Schichtebene ein GMR-Schichtsystem. Die Längsrichtung eines aus dem Schichtsystem gebildeten Streifens soll mit der x-Achse übereinstimmen. Das GMR-Schichtsystem enthält zwei Komponenten, deren Magnetisierungen $M_1$ und $M_2$ unabhängig voneinander in unterschiedliche Richtungen einstellbar sind. $M_1$ ist hier die Magnetisierung der ersten Komponente, deren Richtung im wesentlichen mit der des anliegenden äußeren Magnetfeldes übereinstimmt, im betrachteten Punkt. $M_2$ ist die Magnetisierung der zweiten Komponente, die hier im wesentlichen an die Ausrichtung einer dritten antiferromagnetischen Komponente gekoppelt ist. Zwischen den Richtungen der Magnetisierungen $M_1$ und $M_2$ liegt der Winkel $\beta$. Der spezifische Widerstand $\rho_g$ der GMR-Schicht im betrachteten Punkt ist gegeben durch

$$\rho_g(\beta) = \rho_{g0} + (\Delta\rho_g/2)\cdot(1-\cos(\beta)).$$

$\beta$ ist der widerstandsbestimmende Winkel in jedem Punkt des Streifens. Der spezifische Widerstand ist bei in Streifenlängsrichtung x variierender Richtung der Magnetisierung $M_1$ und der Magnetisierung $M_2$ ebenfalls eine Funktion von x.

Fig. 3 zeigt einen AMR-Streifen 1, dessen Längsausdehnung sich in x-Richtung erstreckt. Der AMR-Streifen 1 wird von einem ersten Rand 2 und einem zweiten Rand 3 begrenzt. Im allgemeinen können die Ränder 2 und 3 entsprechend der Erfindung durch beliebige in x-Richtung stetig variierende Funktionen darstellbar sein. Im dargestellten Fall verlaufen beide Ränder 2; 3 parallel und sind sinusförmig. Die Periodenlänge 13 des Sinus ist wesentlich größer als die Breite 14 des AMR-Streifens 1. Damit fließt der Strom I im AMR-Streifen überall parallel zu den Rändern 2; 3 und seine Richtung verändert sich mit fortschreitendem x stetig. In der Ebene des AMR-Streifens 1 wirkt ein homogenes Magnetfeld $H_h$ mit einer Feldstärke, die größer ist als die Anisotropiefeldstärke des AMR-Streifens 1. Damit ist die Richtung der Magnetisierung M in jedem Punkt des AMR-Streifens 1 im wesentlichen durch die Richtung des homogenen Magnetfeldes $H_h$ gegeben und der widerstandsbestimmende Winkel $\alpha$ ändert sich bei Fortschreiten in x-Richtung ebenfalls stetig. Bei Anwendung von AMR-Streifen 1 in der Winkel- und Positions- oder Längenbestimmung rotiert das eingezeichnete homogene Magnetfeld $H_h$ in der x-y-Ebene. Der Wiederstand des AMR-Streifens 1 als Funktion des Winkels, den das homogene Magnetfeld $H_h$ mit der x-Achse bildet, weist dabei einen minimalen Anteil an Oberwellen auf. Dazu sollte der Winkelbereich, den die Stromrichtung mit der x-Achse einschließt, Werte zwischen 0° und mindestens 15° enthalten. Die obere Grenze für den Betrag des größeren Winkels zwischen Strom und x-Richtung liegt bei 45°.

Die angegebenen Werte für diesen Winkel sollten auch für die Fälle eingehalten werden, bei denen die Ränder der AMR-Streifen nicht durch sinusförmige Kurven darstellbar sind. Vorteilhaft sind die Ränder 2; 3 durch kreisbogenförmige Kurven oder durch Summen parabelförmiger Kurven zweiter und vierter Ordnung zu bilden.

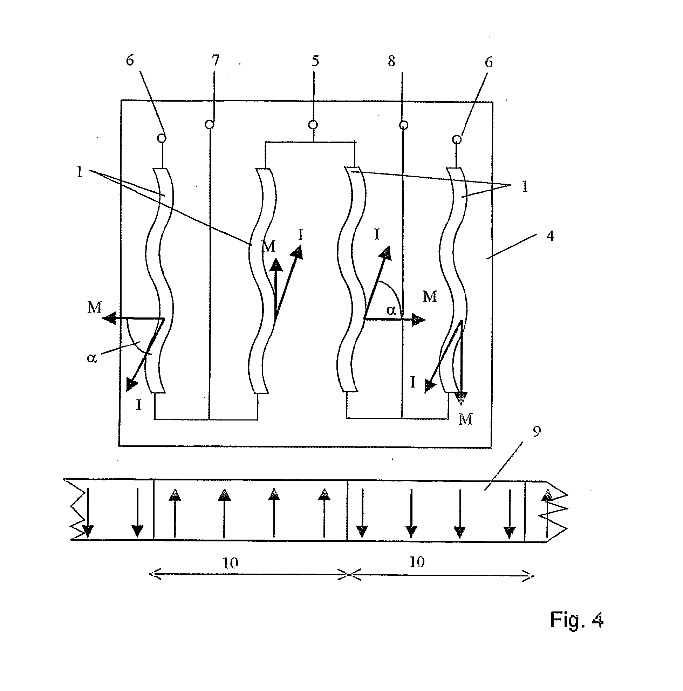

Eine auf der Basis des in Fig. 3 gezeigten AMR-Streifens 1 aufgebaute Sensorbrücke auf einer Chipfläche 4 zur Bestimmung der Position gegenüber einem Maßstab 9 ist in Fig. 4 dargestellt. Der Maßstab 9 ist im Schnitt dargestellt, die Ebene der Chipfläche 4 stimmt mit der Schnittfläche überein. Der Maßstab 9 ist periodisch mit konstanten Pollängen 10 abwechselnd in der Schnittfläche nach oben und nach unten magnetisiert. Die Größenverhältnisse in der Zeichnung sind nicht maßstabsgerecht. Beispielsweise wurden die Streifenbreiten vergrößert dargestellt. Je zwei AMR-Streifen 1 bilden einen Zweig der Wheatstone-Brücke. Die AMR-Streifen 1 sind über nichtmagnetische Leitschichtstreifen miteinander elektrisch verbunden. Mit den Anschlusskontakten 6 ist der positive Pol der Betriebsspannung der Brücke verbunden, mit dem Anschlusskontakt 5 der negative Pol. Die Ausgangsspannung der Brücke kann an den Ausgangskontakten 7 und 8 abgegriffen werden. Wie der Figur 4 zu entnehmen ist, sind die AMR-Streifen 1 im Abstand einer halben Pollänge 10 nebeneinander angeordnet. In jeweils einem Punkt, der bei allen AMR-Streifen gleich weit vom unteren Streifenende entfernt liegt, sind die Richtungen des Stromes I und der Magnetisierung M, wie sie sich unter Einwirkung des Magnetfeldes des magnetischen Maßstabes 9 in der gezeichneten Position einstellt, angegeben. Durch die Unterdrückung von Oberwellenanteile in der Abhängigkeit der Widerstände der AMR-Streifen 1 von der Position ergibt sich als Ausgangssignal der Brücke eine Spannung, die sich periodisch mit der Position ändert, wobei die Periodenlänge der Pollänge 10 entspricht. Diese Spannung ist im wesentlichen durch eine einfache Sinusfunktion darstellbar.

Ein kompletter Positionssensor enthält zwei der dargestellten Wheatstone-Brücken, die um das (n+1/4)-fache der Pollänge 10 gegeneinander versetzt sind, wobei n ganzzahlig ist (n = 0; 1; 2; 3;...). Die Position wird in bekannter Weise aus der Zahl der bereits zurückgelegten Pollängen 10 und dem Bruchteil ermittelt, der sich aus dem Quotienten der beiden Brückensignale durch Anwendung der Arcustangensinterpolation ergibt. Durch die Unterdrückung des Oberwellenanteils in den Brückensignalen ist der Fehler der Positionsangabe gering.

Zur Erhöhung des Widerstandes der Brücken des Positionssensors und zur besseren Nutzung der Chipfläche 4 kann anstelle jedes einzelnen AMR-Streifens 1 eine größere Anzahl von gleich gestalteten AMR-Streifen parallel angeordnet und meanderförmig verbunden sein.

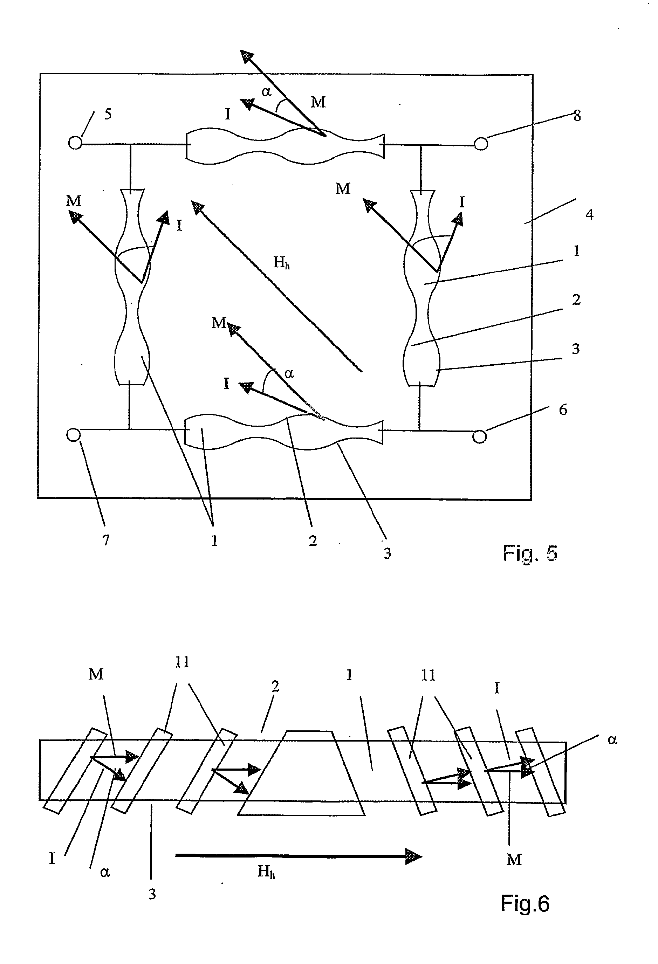

Fig. 5 zeigt als eine andere Ausführungsform der Erfindung eine Brückenanordnung auf einer Chipfläche 4, die Teil eines Winkelsensors ist. Die Verwendung der Anschlusskontakte 5; 6 und der Ausgangskontakte 7; 8 entspricht der nach Fig. 4. Die AMR-Streifen 1 werden hier von Rändern 2; 3 begrenzt, die durch Spiegelung auseinander hervor gehen. Die Stromrichtung stimmt nur direkt auf der Längsachse der AMR-Streifen 1 mit deren Richtung überein. Sie wird jedoch um so mehr der Richtung des Randes 2; 3 parallel verlaufen, je näher der betrachtete Punkt dem jeweiligen Rand 2 oder 3 liegt. Damit ist auch hier eine stetige Änderung der Stromrichtung in Längsrichtung der AMR-Streifen 1 vorhanden. Bei im wesentlichen gleicher Richtung der Magnetisierung der AMR-Streifen 1 in einem homogenen Magnetfeld $H_h$ ist so der widerstandsbestimmende Winkel $\alpha$ ebenfalls einer stetigen Änderung unterworfen. Unterschiedliche widerstandsbestimmende Winkel $\alpha$ sind Voraussetzung für Oberwellenfilterung in den AMR-Streifen 1. Die stetige Änderung dieser Winkel verhindert das Auftreten von Hysterese. In Punkten, die vom Ende der AMR-Streifen 1 und von deren Längsachse gleich weit entfernt sind, sind die widerstandsbestimmenden Winkel $\alpha$ in Fig.5 eingezeichnet. Die Längsrichtungen der beiden AMR-Streifen 1, die jeweils einen Brückenzweig bilden, stehen senkrecht aufeinander. Damit ist die Gegenläufigkeit der Widerstandsänderung der AMR-Streifen 1 in jedem Brückenzweig bei Drehung des homogenen Magnetfeldes $H_h$ gewährleistet, dessen Richtung durch den Winkelsensor bestimmt werden soll. Als Ausgangsignal an den Kontakten 7; 8 ist bei Drehung des homogenen Magnetfeldes $H_h$ um 180° eine ganze Periode der sinusförmigen Ausgangsspannung durchlaufen. Der komplette Winkelsensor enthält neben der dargestellten noch eine gleiche Brücke, die gegenüber der dargestellten um 45° verdreht ist. Der Winkelwert wird aus dem Quotienten der Ausgangssignale beider Brücken nach der bekannten Arcustangensinterpolation bestimmt.

Zur Erhöhung des Widerstandes der Brücken des Winkelsensors und zur besseren Nutzung der Chipfläche 4 kann anstelle jedes einzelnen AMR-Streifens 1 eine größere Anzahl von gleich gestalteten AMR-Streifen parallel angeordnet und meanderförmig verbunden sein.

Eine weitere Realisierungsmöglichkeit von unterschiedlichen Stromrichtungen in AMR-Streifen 1 wird in Fig. 6 dargestellt. Der AMR-Streifen 1 hat gerade und parallele Ränder 2; 3. Auf dem AMR-Streifen 1 sind gegen die Längsrichtung geneigte Leitschichtstreifen 11 angeordnet. Ihre Leitfähigkeit ist um Größenordnungen höher als die der AMR-Schicht. Deshalb fließt der Strom auf kürzestem Wege von einem Leitschichtstreifen 11 zum nächsten und die Stromrichtung steht senkrecht auf der Längsrichtung der Leitschichtstreifen 11. Durch die Neigung der Leitschichtstreifen 11 ist so die Richtung des Stromes I einstellbar. In Fig. 6 sind nur zwei unterschiedliche Stromrichtungen eingezeichnet. Es ist jedoch klar, dass bei Änderung des Neigungswinkels jedes folgenden Leitschichtstreifen 11 gegenüber dem vorigen eine stetige Änderung der Stromrichtung realisierbar ist. Häufig ist die Länge eines AMR-Streifens etwa 1000 Mal größer als die Breite. Der Abstand der Leitschichtstreifen soll von der Größenordnung dieser Breite sein. Bei der so nötigen großen Zahl von Leitschichtstreifen 11 ist eine so geringe Änderung des Neigungswinkels von einem Leitschichtstreifen 11 zum nächsten erforderlich, dass von stetiger Änderung ausgegangen werden kann. In Fig. 6 ist ein

homogenes Magnetfeld $H_h$ parallel zum AMR-Streifen angelegt. In diese Richtung zeigt dann auch die Magnetisierung. Die sich ergebenden widerstandsbestimmenden Winkel $\alpha$ für die beiden Neigungswinkel der Leitschichtstreifen sind eingezeichnet.

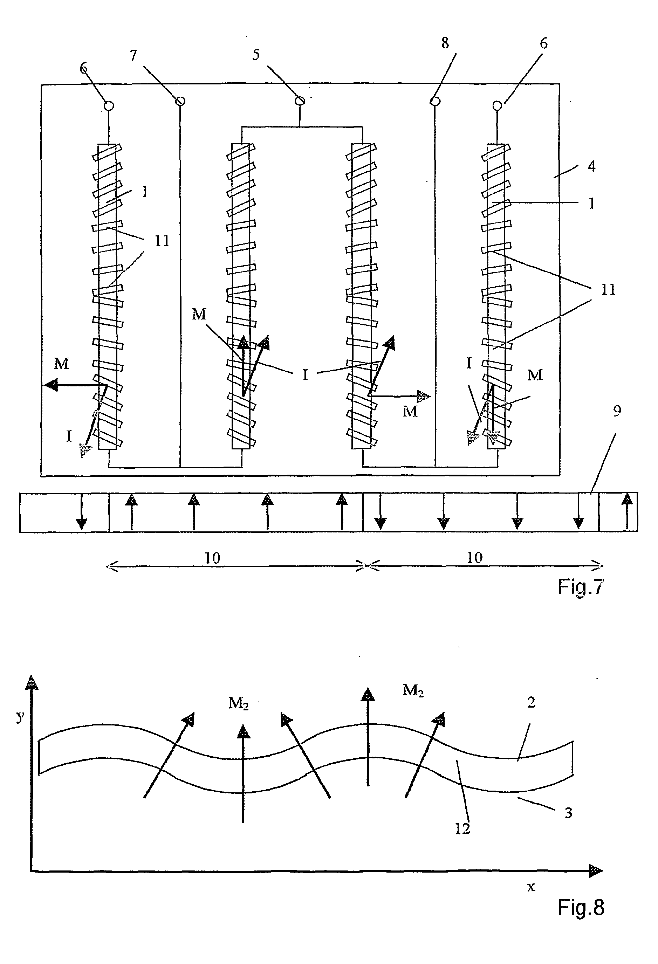

Fig. 7 zeigt eine Wheatstone-Brücke auf einer Chipfläche 4, die aus vier gleichen AMR-Streifen 1 mit Leitschichtstreifen 11 aufgebaut ist und der Positionsmessung dient. Die Chipfläche 4 steht senkrecht über der Oberfläche des Maßstabs 9, dessen Schnittfläche in der Zeichnung dargestellt ist. Der Maßstab 9 ist in gleich langen Pollängen 10 in abwechselnder Richtung magnetisiert. Die Lage der AMR-Streifen 1 und ihre Verbindung und Beschaltung entspricht der in Fig. 4 beschriebenen. Im dargestellten speziellen Fall sind die Leitschichtstreifen 11 auf den AMR-Streifen 1 so aufgebracht, dass je vier gleich lange Teillängen der AMR-Streifen 11 die gleiche Richtung des Stromes I haben. Die Winkel, die die Stromrichtungen mit der Längsrichtung der AMR-Streifen 1 bilden, betragen $\pm$ 6° und $\pm$ 24°. Damit sind in der Positionsabhängigkeit der Widerstandswerte der AMR-Streifen 1 die Oberwellen dritter und fünfter Ordnung eliminiert. Oberwellen geradzahliger Ordnung heben sich durch Differenzbildung in der Brücke auf. So sind alle Oberwellen bis zur 7. Ordnung aus dem Brückenausgangssignal entfernt. Zum vollständigen Positionssensor werden auch hier wieder zwei um das (1+1/4)-fache der Pollänge 10 versetzte Brücken benötigt. Auch hier kann zur Erhöhung des Brückenwiderstandes jeder AMR-Streifen 1 durch mehrere parallele, mäanderförmig verbundene gleiche AMR-Streifen ersetzt sein.

Anders als in Fig. 7 dargestellt, kann der Winkel der Stromrichtung gegen die Längsrichtung der AMR-Streifen 1 auch von einem Abstand der Leitschichtstreifen 11 zum nächsten stetig und kontinuierlich geändert sein. Durch Berechnung der Brückenausgangssignate ist eine optimale Anpassung an die geforderte Messgenauigkeit für den Positionswert möglich.

Aus AMR-Streifen 1 mit darauf angeordneten Leitschichtstreifen 11 können gemäß der Erfindung auch Winkelsensoren aufgebaut sein. Durch geeignete Wahl der Winkel zwischen der Längsrichtung der Leitschichtstreifen 11 und der Längsrichtung der AMR-Streifen ist es dabei möglich, dass die Längsrichtungen der AMR-Streifen 1 in den beiden Widerständen eines Brückenzweiges parallel zueinander gerichtet sind oder 90° gegeneinander geneigt sind oder jeden Winkelwert zwischen 0° und 90° miteinander einschließen.

Bei allen magnetoresistiven Sensoranordnungen mit Oberwellenfilterung ist im Vergleich mit solchen ohne diese eine verminderte Amplitude des Ausgangssignales als Funktion des Winkels oder der Position unvermeidlich. Im Falle der AMR-Streifen 1 mit Leitschichtstreifen 11 fällt hat diese Verminderung den geringsten Wert. Das ist dadurch bedingt, dass hier in jedem Widerstand in den Streifen nur über unterschiedliche Stromwinkel gemittelt werden muss und nicht auch noch über unterschiedliche Winkel der Magnetisierung in den jeweiligen AMR-Streifen 1. In den geraden AMR-Streifen liegt überall die gleiche Magnetisierungsrichtung vor.

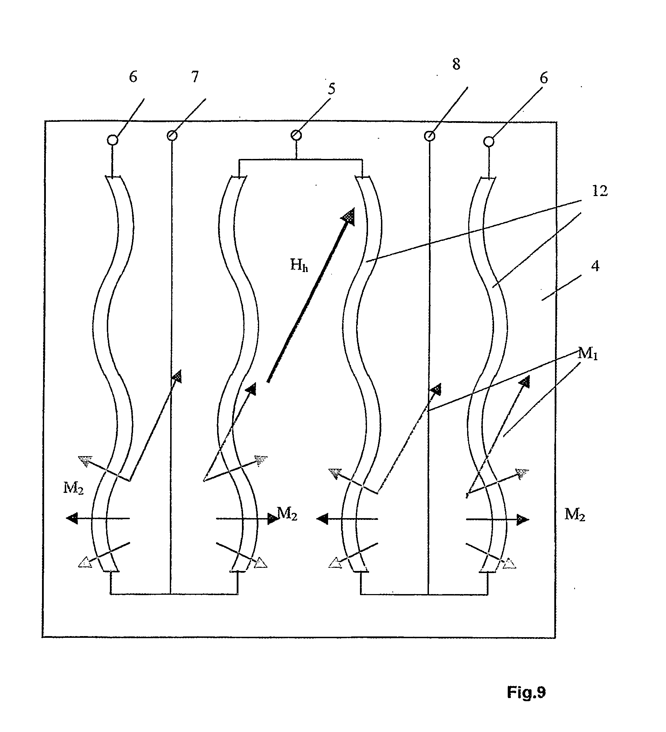

Die Anwendung der Erfindung bei GMR-Sensoren wird in Fig. 8 und Fig. 9 an einem weiteren Beispiel erläutert. Fig. 8 zeigt einen GMR-Streifen 12 , dessen Schichtebene sich in der x-y-Ebene befindet und dessen Längsrichtung mit der x-Richtung übereinstimmt. Die Richtung der Magnetisierung $M_1$ (Fig. 2) der ersten Komponente der GMR-Schicht, die im wesentlichen der Richtung des äußeren Magnetfeldes folgt, ist hier nicht dargestellt. Der GMR-Streifen 12 ist von den Rändern 2 und 3 begrenzt. Die Ränder 2; 3 sind in der Zeichnung durch gleiche sinusförmige Kurven darstellbar und verlaufen bei jedem x-Wert parallel. Die Richtung der Magnetisierung $M_2$ der zweiten Komponente der GMR-Schicht steht, wie aus der Zeichnung ersichtlich, überall senkrecht zu den Rändern 2; 3. Diese Verteilung der Magnetisierung $M_2$ ist durch das Feld eines Stromes durch den GMR-Streifen erzeugt worden, der zu einer Zeit eingespeist wurde, als der GMR-Streifen 12 sich von einer höheren Temperatur unter seine Neel-Temperatur abkühlte. Der genaue Vorgang dieser Magnetisierungseinstellung ist bekannt und nicht Gegenstand der vorliegenden Erfindung. Die mit fortschreitendem x-Wert stetige und kontinuierliche Änderung der Magnetisierung $M_2$ verursacht bei angelegtem äußeren Feld und der damit im wesentlichen konstanten Richtung der Magnetisierung $M_1$ der ersten Komponente eine stetige Änderung des widerstandsbestimmenden Winkels $\beta$ (Fig.2).

Fig. 9 zeigt eine Winkelsensorbrücke, die aus GMR-Streifen nach Fig. 8 aufgebaut ist. Auf einer Chipfläche 4 befinden sich vier GMR-Streifen 12, die durch leitende, nichtmagnetische Verbindungen und Anschlusskontakte entsprechend der Beschreibung zu Fig. 4. zu einer Wheatstone-Brücke vervollständigt wurden. In der Chipfläche 4 wirkt ein homogenes Magnetfeld $H_h$, dessen Richtung in der Ebene der Chipfläche 4 rotieren kann und dessen Winkel gegen die untere Kante der Chipfläche 4 bestimmt werden soll. Die Längsrichtungen der vier GMR-Streifen 12 liegen parallel, die beiden GMR-Streifen jeden Brükkenzweiges gehen durch Spiegelung auseinander hervor. Das trifft auch für die Richtungen der Magnetisierung $M_2$ der zweiten Komponente der GMR-Schicht zu. Auf diese Weise wird die Gegenläufigkeit der Widerstandsänderung der Widerstände jeden Brückenzweiges bei Drehung des Magnetfeldes $H_h$ gewährleistet. Die Magnetisierung der ersten Komponente der GMR-Schicht $M_1$ stellt sich im wesentlichen in Richtung des Magnetfeldes $H_h$ ein. Damit ist entlang jeden GMR-Streifens 12 eine stetige und kontinuierliche Änderung des widerstandsbestimmenden Winkels $\beta$ bei jedem angelegten Magnetfeld $H_h$ vorhanden und die Ausbildung von Hystereseebereichen erschwert. Durch unterschiedliche widerstandsbestimmende Winkel in jedem Brückenwiderstand wird eine Oberwellenfilterung bewirkt. Um eine praktisch bedeutende Unterdrückung des Oberwellenanteiles zu erzielen, ist der Betrag des maximalen Anstiegswinkel der Randkurven in Fig. 8 im Bereich von 30° bis 90° zu wählen. Die Wahl des optimalen Verhältnisses zwischen Periodenlänge und maximalen Anstiegswinkel der Randkurven erfolgt durch Berechnung des Brückenausgangssignales.

Der vollständige Winkelsensor enthält auch hier eine zweite Brücke gleichen Aufbaus, die gegen die gezeichnete jedoch um 90° verdreht angeordnet ist. Der zu bestimmende Winkelwert ergibt sich aus dem Quotienten beider Brückensignale durch Anwendung der Arcustangensinterpolation.

Die Ränder 2; 3 der GMR-Streifen können durch unterschiedliche Kurven wiedergegeben werden, die stetig verlaufen. Vorteilhaft sind kreisbogenförmige Kurvenabschnitte oder Summen von Parabeln zweiter und vierter Ordnung.

Die Werte der Widerstände der Brücke können dadurch erhöht sein, dass anstelle jedes einzelnen GMR-Streifens 12 untereinander gleiche parallele GMR-Streifen mit mäanderförmiger Verbindung benutzt werden.

Die Einstellung der Richtung der Magnetisierung $M_2$ der zweiten Komponente der GMR-Schicht erfolgt in vorteilhafter Weise durch Kombination von Feldern von Strömen durch die GMR-Streifen und von außen angelegten Magnetfeldern bei der Abkühlung der GMR-Streifen 12 unter die Neel-Temperatur.

Der Aufbau von Positionssensoren auf der Basis von GMR-Streifen 12 wird hier nicht im einzelnen ausgeführt, ist aber Teil der vorliegenden Erfindung und dürfte aus den angegebenen Ausführungsbeispielen einfach ableitbar sein.

Bezugszeichenliste

| 1 | AMR-Streifen |
|---|---|
| 2 | Erster Rand |
| 3 | Zweiter Rand |
| 4 | Chipfläche |
| 5 | Betriebsspannungskontakt |
| 6 | Betriebsspannungskontakt |
| 7 | Brückenausgangsspannungskontakt |
| 8 | Brückenausgangsspannungskontakt |
| 9 | Maßstab |
| 10 | Pollänge des Maßstabes |
| 11 | Leitschichtstreifen |
| 12 | GMR-Streifen |
| 13 | Periodenlänge der Randkurve |
| 14 | Breite des Streifens |
| $\alpha$ | widerstandsbestimmender Winkel |
| $\beta$ | widerstandsbestimmender Winkel |
| $H_h$ | homogenes Magnetfeld |
| M | Magnetisierung der AMR-Schicht |
| $M_1$ | Magnetisierung der ersten Komponente der GMR-Schicht |
| $M_2$ | Magnetisierung der zweiten Komponente der GMR-Schicht |
| I | Strom |
| x, y | Koordinaten der Schichtebene |

**Patentansprüche**

**1.** Magnetoresistiver Sensor zur Bestimmung eines Winkels der Sensorausrichtung relativ zu einem gegenüber dem Sensor drehbaren Magnetfeld ($H_h$) oder zur Bestimmung einer Position des Sensors relativ zu einem gegenüber dem Sensor verschiebbaren in Richtung der Verschiebung periodischen Magnetfeld, der aus mindestens zwei Halb- oder Vollbrücken besteht, die phasenverschobene periodische Signale liefern, und deren Widerstände aus Streifen von magnetoresistiven Materialien gebildet sind, die entweder den anisotropen magnetoresistiven (AMR) Effekt, bei dem der Widerstandswert durch einen widerstandsbestimmenden Winkel ($\alpha$) zwischen der Richtung des Stromes (I) und der Richtung der Magnetisierung (M) bestimmt ist, oder den gigantischen magnetoresistiven (GMR) Effekt, bei dem der Widerstandswert durch einen widerstandsbestimmenden Winkel ($\beta$) zwischen der im Feld drehbaren Magnetisierung ($M_1$) einer ersten Komponente und der im Feld festen Magnetisierung ($M_2$) einer zweiten Komponente des magnetoresistiven Materials bestimmt ist, aufweisen, **dadurch gekennzeichnet, dass** zur Unterdrückung von Oberwellenanteilen in den Signalen der widerstandsbestimmende Winkel ($\alpha$; $\beta$) entlang der Längsausdehnung (x) der Streifen dadurch stetig verändert ist, dass im Falle des AMR-Effektes die Streifen so geformt sind, dass die Richtung des Stromes (I) entlang der Längsausdehnung der Streifen von Ort zu Ort stetig variiert oder dass im Fall des GMR-Effektes die Richtung der im Feld festen Magnetisierung ($M_2$) der zweiten Komponente des magnetoresistiven Materials entlang der Längsausdehnung (x) der Streifen von Ort zu Ort stetig variierend eingestellt ist.

2. Magnetoresistiver Sensor nach Anspruch 1, **dadurch gekennzeichnet, dass** jeweils an den Enden der Streifen (1; 12) die Richtung des Stromes oder die feste Magnetisierung ($M_2$) mit der Richtung der Längsausdehnung (x) Winkel mit demselben Betrag bildet.

3. Magnetoresistiver Sensor nach Anspruch 2, **dadurch gekennzeichnet, dass** der Winkel des Stromes (I) gegen die Längsausdehnung (x) oder der Winkel der festen Magnetisierung ($M_2$) gegen die Längsausdehnung (x) symmetrisch zur Streifenmitte verläuft.

4. Magnetoresistiver Sensor nach Anspruch 1, **dadurch gekennzeichnet, dass** der Winkel des Stromes (I) oder der festen Magnetisierung ($M_2$) gegen die Längsrichtung (x) der Streifen in Längsrichtung der Streifen periodisch verläuft.

5. Magnetoresistiver Sensor nach Anspruch 1 zur Bestimmung einer Position, **dadurch gekennzeichnet, dass** alle Widerstände der Halb- oder Vollbrücken durch zueinander parallele Streifen (1; 12) untereinander gleicher Form gebildet sind, deren Längsrichtung (x) sich senkrecht zur Messrichtung erstreckt.

6. Magnetoresistiver Sensor nach Anspruch 1 zur Bestimmung eines Winkels, **dadurch gekennzeichnet, dass** jeder Widerstand der Halb- oder Vollbrücken durch zueinander parallele Streifen (1; 12) untereinander gleicher Form gebildet ist, und die Längsrichtungen der Streifen (1; 12) der unterschiedlichen Widerstände durch Verdrehung um bestimmte Versatzwinkel auseinander hervorgehen.

7. Magnetoresistiver Sensor nach Anspruch 6, **dadurch gekennzeichnet, dass** die Streifen (1) der Widerstände aus einem Material bestehen, das den AMR-Effekt aufweist, dass der Versatzwinkel innerhalb jeder Halbbrücke 90° beträgt, und dass der Versatzwinkel zwischen den einander entsprechenden Widerständen der beiden Halb- oder Vollbrücken 45° beträgt.

8. Magnetoresistiver Sensor nach Anspruch 6, **dadurch gekennzeichnet, dass** die Streifen (12) der Widerstände aus einem Material bestehen, das den GMR-Effekt aufweist, dass der Versatzwinkel innerhalb jeder Halbbrücke 180° beträgt, und dass der Versatzwinkel zwischen den einander entsprechenden Widerständen der beiden Halb- oder Vollbrücken 90° beträgt.

9. Magnetoresistiver Sensor nach Anspruch 1 mit Streifen (1), die aus einem Material bestehen, das den AMR-Effekt aufweist, **dadurch gekennzeichnet, dass** die Stromrichtung in den Streifen dadurch von Ort zu Ort stetig variiert, dass die Streifenränder (2; 3) durch in Streifenlängsrichtung stetig variierende Funktionen darstellbar sind und der Strom mindestens in den randnahen Bereichen parallel zum Rand (2; 3) gerichtet ist.

10. Magnetoresistiver Sensor nach Anspruch 9, **dadurch gekennzeichnet, dass** beide Ränder (2; 3) jedes Streifens (1) durch die gleiche stetig variierende Funktion darstellbar sind und damit in jedem Punkt in Streifenlängsrichtung parallel verlaufen.

11. Magnetoresistiver Sensor nach Anspruch 9, **dadurch gekennzeichnet, dass** die stetig variierende Funktion eine periodische Funktion ist.

12. Magnetoresistiver Sensor nach Anspruch 11, **dadurch gekennzeichnet, dass** die stetig periodische Funktion eine Periodenlänge (13) aufweist, die wesentlich größer als die Breite (14) der Streifen (1) ist.

13. Magnetoresistiver Sensor nach Anspruch 12, **dadurch gekennzeichnet, dass** die periodische Funktion als Sinusfunktion darstellbar ist.

14. Magnetoresistiver Sensor nach Anspruch 12, **dadurch gekennzeichnet, dass** die periodische Funktion als Folge von Kreisbögen abwechselnder Krümmung darstellbar ist.

15. Magnetoresistiver Sensor nach Anspruch 12, **dadurch gekennzeichnet, dass** die periodische Funktion als Folge der Summe von Parabeln zweiter und vierter Ordnung abwechselnder Krümmung darstellbar ist.

16. Magnetoresistiver Sensor nach Anspruch 12, **dadurch gekennzeichnet, dass** die Amplitude der periodischen Funktion durch eine Optimierung bezüglich eines geringen Oberwellenanteiles der Ausgangsspannung der Halb- oder Vollbrücke bei einer größtmöglichen Amplitude der Ausgangsspannung bei Drehung des Magnetfeldes ($H_h$) gegenüber dem Sensor bestimmt worden ist.

**17.** Magnetoresistiver Sensor nach Anspruch 1, mit Streifen (1), die von geraden Rändern (2; 3) begrenzt und von konstanter Breite (14) sind, **dadurch gekennzeichnet, dass** die Stromrichtungen (I) in den Streifen (1) mit den Rändern (2; 3) der Streifen (1) dadurch unterschiedliche Winkel bilden, dass die Streifen (1) magnetoresistiven Materials mit einer Vielzahl von Leitschichtstreifen (11) in einem Abstand voneinander, der von gleicher Größenordnung wie die Breite (14) der magnetoresistiven Streifen ist, versehen sind, deren Längsrichtungen mit der Längsrichtung der magnetoresistiven Streifen (1) entlang dieser von Ort zu Ort unterschiedliche Zwischenwinkel bilden.

**18.** Magnetoresistiver Sensor nach Anspruch 17, **dadurch gekennzeichnet, dass** die Zwischenwinkel so gewählt sind, dass der Verlauf des Stromes (I) über der Längsrichtung (x) der magnetoresistiven Streifen (1) durch eine Sinusfunktion darstellbar ist.

**19.** Magnetoresistiver Sensor nach Anspruch 17, **dadurch gekennzeichnet, dass** die Zwischenwinkel so gewählt sind, dass der Verlauf des Stromes (I) über der Längsrichtung der magnetoresistiven Streifen (1) Winkel durch die Summe von Parabeln zweiter und vierter Ordnung abwechselnder Krümmung darstellbar ist.

**20.** Magnetoresistiver Sensor nach Anspruch 1 mit Widerstandstreifen aus einem Material, das den GMR-Effekt aufweist, **dadurch gekennzeichnet, dass** jeweils die gegenüberliegenden Streifenränder (2; 3) durch gleiche in, Streifenlängsrichtung stetig variierende Funktionen darstellbar sind und dass die Magnetisierungsrichtung ($M_2$) der zweiten Komponente durch das Magnetfeld eines Stromes (I) durch die Streifen eingestellt ist und so die Magnetisierungsrichtung ($M_2$) stets senkrecht auf dem jeweiligen Rand (2; 3) steht.

**21.** Magnetoresistiver Sensor nach Anspruch 20, **dadurch gekennzeichnet, dass** die stetig variierende Funktion durch eine Sinuskurve darstellbar ist.

**22.** Magnetoresistiver Sensor nach Anspruch 20, **dadurch gekennzeichnet, dass** die stetig variierende Funktion als Folge von Kreisbögen abwechselnder Krümmung darstellbar ist.

**23.** Magnetoresistiver Sensor nach Anspruch 20, **dadurch gekennzeichnet, dass** die periodische Funktion als Folge der Summe von Parabeln zweiter und vierter Ordnung abwechselnder Krümmung darstellbar ist.

**24.** Magnetoresistiver Sensor nach Anspruch 20, **dadurch gekennzeichnet, dass** die Magnetisierungsrichtung ($M_2$) der zweiten Komponente durch das Magnetfeld eines Stromes durch die Streifen (12) in Kombination mit einem von außen angelegten homogenen Magnetfeld ($H_h$) eingestellt ist.

**Claims**

**1.** Magneto-resistive sensor for determining an angle of the sensor alignment relative to a magnetic field ($H_h$) that can be rotated with respect to the sensor, or for determining a position of the sensor relative to a magnetic field that can be displaced with respect to the sensor and is periodic in the direction of displacement, comprising at least two half bridges or full bridges which supply phase-shifted periodic signals and whose resistors are formed from strips of magneto-resistive materials which exhibit either the anisotropic magneto-resistive effect (AMR), in which the resistance value is determined by a resistance-determining angle ($\alpha$) between the direction of the current (I) and the direction of magnetisation (M), or the gigantic magneto-resistive effect (GMR), in which the resistance value is determined by a resistance-determining angle ($\beta$) between the magnetisation ($M_1$), which can be rotated in the field, of a first component and the magnetisation ($M_2$), which is fixed in the field, of a second component of the magneto-resistive material, **characterised in that** to suppress harmonic fractions in the signals the resistance-determining angle ($\alpha$; $\beta$) is continuously changed along the longitudinal extent (x) of the strips in such a way that in the case of the AMR effect the strips are shaped such that the direction of the current (I) continuously varies from place to place along the longitudinal extent of the strips, or in such a way that in the case of the GMR effect the direction of the magnetisation ($M_2$), which is fixed in the field, of the second component of the magneto-resistive material is adjusted along the longitudinal extent (x) of the strips so as to continuously vary from place to place.

**2.** Magneto-resistive sensor according to claim 1, **characterised in that** at the ends of the strips (1; 12) in each case the direction of the current or the fixed magnetisation ($M_2$) forms angles of the same size with the direction of the longitudinal extent (x).

3. Magneto-resistive sensor according to claim 2, **characterised in that** the angle of the current (I) against the longitudinal extent (x) or the angle of the fixed magnetisation ($M_2$) against the longitudinal extent (x) runs symmetrically with respect to the centre of the strip.

4. Magneto-resistive sensor according to claim 1, **characterised in that** the angle of the current (I) or the fixed magnetisation ($M_2$) against the longitudinal extent (x) of the strips runs periodically in the longitudinal direction of the strips.

5. Magneto-resistive sensor according to claim 1 for determining a position, **characterised in that** all resistors of the half or full bridges are formed by strips (1; 12) that are mutually parallel and have the same shape, whose longitudinal direction (x) extends perpendicular to the measuring direction.

6. Magneto-resistive sensor according to claim 1 for determining an angle, **characterised in that** each resistor of the half or full bridge is formed by mutually parallel strips (1; 12) which have the same shape, and the longitudinal directions of the strips (1; 12) of the various resistors result from each other by rotation about specific offset angles.

7. Magneto-resistive sensor according to claim 6, **characterised in that** the strips (1) of the resistors are made from a material which exhibits the AMR effect, **in that** the offset angle inside each half bridge is 90°, and **in that** the offset angle between the mutually corresponding resistors of the two half or full bridges is 45°.

8. Magneto-resistive sensor according to claim 6, **characterised in that** the strips (12) of the resistors are made from a material which exhibits the GMR effect, **in that** the offset angle inside each half bridge is 180°, and **in that** the offset angle between the mutually corresponding resistors of the two half or full bridges is 90°.

9. Magneto-resistive sensor according to claim 1, comprising strips (1) which are made from a material which exhibits the AMR effect, **characterised in that** the current direction in the strips continuously varies from place to place, **in that** the strip edges (2; 3) can be represented by functions that vary continuously in the strip longitudinal direction and the current is parallel to the edge (2; 3), at least in the regions that are close to the edge.

10. Magneto-resistive sensor according to claim 9, **characterised in that** two edges (2; 3) of each strip (1) can be represented by the same continuously varying function and therefore run parallel at each point in the strip longitudinal direction.

11. Magneto-resistive sensor according to claim 9, **characterised in that** the continuously varying function is a periodic function.

12. Magneto-resistive sensor according to claim 11, **characterised in that** the continuously periodic function has a period length (13) which is significantly greater than the width (14) of the strips (1).

13. Magneto-resistive sensor according to claim 12, **characterised in that** the periodic function can be represented as a sine function.

14. Magneto-resistive sensor according to claim 12, **characterised in that** the periodic function can be represented as a sequence of arcs of a circle with alternating curvature.

15. Magneto-resistive sensor according to claim 12, **characterised in that** the periodic function can be represented as a sequence of the total of second and fourth order parabolas with alternating curvature.

16. Magneto-resistive sensor according to claim 12, **characterised in that** the amplitude of the periodic function has been determined by an optimisation with respect to a low harmonic fraction of the output voltage of the half or full bridge with the greatest possible amplitude of the output voltage on rotation of the magnetic field ($H_h$) with respect to the sensor.

17. Magneto-resistive sensor according to claim 1, comprising strips (1) which are bounded by straight edges (2; 3) and have a constant width (14), **characterised in that** the current directions (I) in the strips (1) form different angles with the edges (2; 3) of the strips (1) **in that** the strips (1) of magneto-resistive material are provided with a large number of conductive layer strips (11) at a spacing from each other, which is the same size as the width (14) of the magneto-resistive strips, whose longitudinal directions form different intermediate angles from place to place along and with the longitudinal direction of the magneto-resistive strips (1).

18. Magneto-resistive sensor according to claim 17, **characterised in that** the intermediate angles are selected such that the course of the current (I) over the longitudinal direction (x) of the magneto-resistive strips (1) can be represented by a sine function.

19. Magneto-resistive sensor according to claim 17, **characterised in that** the intermediate angles are selected such that the course of the current (I) over the longitudinal direction of the magneto-resistive strips (1) angle can be represented by the total of second and fourth order parabolas with alternating curvature.

20. Magneto-resistive sensor according to claim 1 having resistor strips made from a material which exhibits the GMR effect, **characterised in that** the opposing strip edges (2; 3) respectively can be represented by identical functions that vary continuously in the strip longitudinal direction, and **in that** the direction of magnetisation ($M_2$) of the second component is adjusted by the magnetic field of a current (I) through the strips and the magnetisation direction ($M_2$) is therefore always perpendicular to the respective edge (2; 3).

21. Magneto-resistive sensor according to claim 20, **characterised in that** the continuously varying function can be represented by a sine curve.

22. Magneto-resistive sensor according to claim 20, **characterised in that** the continuously varying function can be represented as a sequence of arcs of a circle with alternating curvature.

23. Magneto-resistive sensor according to claim 20, **characterised in that** the periodic function can be represented as a sequence of the total of second and fourth order parabolas with alternating curvature.

24. Magneto-resistive sensor according to claim 20, **characterised in that** the magnetisation direction ($M_2$) of the second component is adjusted by the magnetic field of a current through the strips (12) in combination with an externally applied homogeneous magnetic field ($H_h$).

**Revendications**

1. Capteur magnétorésistif servant à déterminer un angle de l'orientation du capteur par rapport à un champ magnétique ($H_h$) tournant par rapport au capteur ou à déterminer une position du capteur par rapport à un champ magnétique déplaçable par rapport au capteur, périodique en direction du déplacement, qui se compose d'au moins deux demi-ponts ou ponts intégraux qui délivrent des signaux périodiques déphasés et dont les résistances sont formées de bandes de matériaux magnétorésistifs qui présentent soit l'effet magnétorésistif anisotrope (AMR), dans lequel la valeur de résistance est déterminée par un angle déterminant la résistance ($\alpha$) entre la direction du courant (I) et la direction de la magnétisation (M), ou l'effet magnétorésistif géant (GMR), dans lequel la valeur de résistance est déterminée par un angle déterminant la résistance ($\beta$) entre la magnétisation tournante ($M_1$) dans le champ d'un premier composant et la magnétisation fixe ($M_2$) dans le champ d'un deuxième composant du matériau magnétorésistif, **caractérisé en ce que** pour supprimer des composantes harmoniques dans les signaux, on fait varier continuellement l'angle déterminant la résistance ($\alpha$, $\beta$) le long de l'extension longitudinale (x) des bandes par le fait que, dans le cas de l'effet AMR, les bandes sont formées de manière que la direction du courant (I) le long de l'extension longitudinale des bandes varie continuellement de place en place ou que, dans le cas de l'effet GMR, la direction de la magnétisation fixe ($M_2$) dans le champ du deuxième composant du matériau magnétorésistif est réglée de manière à être continuellement variable de place en place le long de l'extension longitudinale (x) des bandes.

2. Capteur magnétorésistif selon la revendication 1, **caractérisé en ce qu'**aux extrémités des bandes (1 ; 12) la direction du courant ou la magnétisation fixe ($M_2$) forme avec la direction de l'extension longitudinale (x) des angles de même valeur.

3. Capteur magnétorésistif selon la revendication 2, **caractérisé en ce que** l'angle du courant (I) avec l'extension longitudinale (x) ou l'angle de la magnétisation fixe ($M_2$) avec l'extension longitudinale (x) s'étend symétriquement par rapport au centre des bandes.

**4.** Capteur magnétorésistif selon la revendication 1, **caractérisé en ce que** l'angle du courant (I) ou de la magnétisation fixe ($M_2$) avec l'extension longitudinale (x) des bandes s'étend périodiquement dans la direction longitudinale des bandes.

**5.** Capteur magnétorésistif selon la revendication 1 servant à déterminer une position, **caractérisé en ce que** toutes les résistances des demi-ponts ou des ponts intégraux sont formées de bandes parallèles les unes aux autres (1 ; 12) de même forme entre elles dont la direction longitudinale (x) s'étend perpendiculairement à la direction de mesure.

**6.** Capteur magnétorésistif selon la revendication 1 servant à déterminer un angle, **caractérisé en ce que** chaque résistance des demi-ponts ou des ponts intégraux est formée de bandes parallèles les unes aux autres (1 ; 12) de même forme entre elles, et les directions longitudinales des bandes (1 ; 12) des différentes résistances résultent les unes des autres par rotation d'angles de décalage définis.

**7.** Capteur magnétorésistif selon la revendication 6, **caractérisé en ce que** les bandes (1) des résistances sont composées d'un matériau qui présente l'effet AMR, que l'angle de décalage à l'intérieur de chaque demi-pont est de 90° et que l'angle de décalage entre les résistances mutuellement correspondantes des deux demi-ponts ou ponts intégraux est de 45°.

**8.** Capteur magnétorésistif selon la revendication 6, **caractérisé en ce que** les bandes (1) des résistances sont composées d'un matériau qui présente l'effet GMR, que l'angle de décalage à l'intérieur de chaque demi-pont est de 180° et que l'angle de décalage entre les résistances mutuellement correspondantes des deux demi-ponts ou ponts intégraux est de 90°.

**9.** Capteur magnétorésistif selon la revendication 1 avec des bandes (1) qui sont composées d'un matériau qui présente l'effet AMR, **caractérisé en ce que** la direction du courant dans les bandes varie continuellement de place en place du fait que les bords de bande (2 ; 3) sont représentables par des fonctions continuellement variables dans la direction longitudinale des bandes et le courant est dirigé parallèlement au bord (2 ; 3) au moins dans les zones proches des bords.

**10.** Capteur magnétorésistif selon la revendication 9, **caractérisé en ce que** les deux bords (2 ; 3) de chaque bande (1) sont représentables par la même fonction continuellement variable et s'étendent donc parallèlement en chaque point dans la direction longitudinale des bandes.

**11.** Capteur magnétorésistif selon la revendication 9, **caractérisé en ce que** la fonction continuellement variable est une fonction périodique.

**12.** Capteur magnétorésistif selon la revendication 11, **caractérisé en ce que** la fonction continuellement périodique présente une longueur de période (13) qui est beaucoup plus grande que la largeur (14) des bandes (1).

**13.** Capteur magnétorésistif selon la revendication 12, **caractérisé en ce que** la fonction périodique est représentable par une fonction sinus.

**14.** Capteur magnétorésistif selon la revendication 12, **caractérisé en ce que** la fonction périodique est représentable par une suite d'arcs de cercle de courbure alternante.

**15.** Capteur magnétorésistif selon la revendication 12, **caractérisé en ce que** la fonction périodique est représentable par une suite de la somme de paraboles de deuxième et quatrième ordre de courbure alternante.

**16.** Capteur magnétorésistif selon la revendication 12, **caractérisé en ce que** l'amplitude de la fonction périodique a été déterminée par une optimisation quant à une faible composante harmonique de la tension de sortie du demi-pont ou du pont intégral à la plus grande amplitude possible de la tension de sortie lors de la rotation du champ magnétique ($H_h$) par rapport au capteur.

**17.** Capteur magnétorésistif selon la revendication 1, avec des bandes (1) qui sont limitées par des bords droits (2 ; 3) et sont de largeur constante (14), **caractérisé en ce que** les directions de courant (I) dans les bandes (1) forment avec les bords (2 ; 3) des bandes (1) des angles différents du fait que les bandes (1) en matériau magnétorésistif sont pourvues d'une pluralité de bandes stratifiées conductrices (11) à une distance les unes des autres qui est du même ordre de grandeur que la largeur (14) des bandes magnétorésistives, dont les directions longitudinales forment avec la direction longitudinale des bandes magnétorésistives (1), le long de celle-ci, des angles intermédiaires différents de place en place.

18. Capteur magnétorésistif selon la revendication 17, **caractérisé en ce que** les angles intermédiaires sont choisis de manière que l'allure du courant (I) en fonction de la direction longitudinale (x) des bandes magnétorésistives (1) soit représentable par une fonction sinus.

19. Capteur magnétorésistif selon la revendication 17, **caractérisé en ce que** les angles intermédiaires sont choisis de manière que l'allure du courant (I) en fonction de la direction longitudinale des bandes magnétorésistives (1) soit représentable par la somme de paraboles de deuxième et quatrième ordre de courbure alternante.

20. Capteur magnétorésistif selon la revendication 1 avec des bandes résistantes dans un matériau qui présente l'effet GMR, **caractérisé en ce que** les bords de bande (2 ; 3) opposés sont représentables par les mêmes fonctions continuellement variables dans la direction longitudinale des bandes et que la direction de magnétisation ($M_2$) du deuxième composant est réglée par le champ magnétique d'un courant (I) à travers les bandes et donc que la direction de magnétisation ($M_2$) est toujours perpendiculaire au bord (2 ; 3) respectif.

21. Capteur magnétorésistif selon la revendication 20, **caractérisé en ce que** la fonction continuellement variable est représentable par une courbe sinusoïdale.

22. Capteur magnétorésistif selon la revendication 20, **caractérisé en ce que** la fonction continuellement variable est représentable par une suite d'arcs de cercle de courbure alternante.

23. Capteur magnétorésistif selon la revendication 20, **caractérisé en ce que** la fonction périodique est représentable par une suite de la somme de paraboles de deuxième et quatrième ordre de courbure alternante.

24. Capteur magnétorésistif selon la revendication 20, **caractérisé en ce que** la direction de magnétisation ($M_2$) du deuxième composant est réglée par le champ magnétique d'un courant à travers les bandes (12) en combinaison avec un champ magnétique homogène ($H_h$) appliqué de l'extérieur.

Fig.1

Fig.2

Fig. 3

Fig. 4

Fig. 5

Fig.6

Fig.7

Fig.8

Fig.9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0730162 A
- US 5686837 A
- DE 10130620
- DE 3514457
- WO 0206845 A1
- DE 19839450 A1
- WO 0206445 A1